# FASCICULE DE BREVET EUROPEEN

(11) **EP 2 648 008 B1**
(45) Date de publication et mention de la délivrance du brevet: **11.05.2016**
(21) Numéro de dépôt: 13305363.7
(22) Date de dépôt: 25.03.2013
(51) Int. Cl.: G01R 27/18, G01R 31/02, H02H 3/16, H02H 3/17, G01R 31/08, H02H 3/33

(54) **Système de contrôle d'isolement pour réseau électrique sécurisé**
Isolierungskontrollsystem für gesichertes Stromnetz
Insulation monitoring system for secured electric power system

(30) Priorité: 06.04.2012 FR 1201039
(43) Date de publication de la demande: 09.10.2013
(73) Titulaire: Schneider Electric Industries SAS, 92500 Rueil-Malmaison (FR)
(72) Inventeur: Dalban Pilon, Bernard, 38050 Grenoble Cedex 09 (FR); Gruffaz, Franck, 38050 Grenoble Cedex 09 (FR)
(74) Mandataire: Tripodi, Paul

(56) Documents cités:
- EP-A1- 2 006 694
- DE-A1- 10 307 972
- DE-A1- 19 826 410
- FR-A1- 2 963 679
- KR-Y1- 200 401 675

## Description

### DOMAINE TECHNIQUE

L'invention concerne l'identification de la présence d'un défaut d'isolement pour un réseau de distribution électrique à neutre isolé comprenant des dérivations, associée notamment à la localisation et la mesure de défauts d'isolement. L'invention se rapporte plus particulièrement à la redondance du contrôle d'isolement dans les applications le requérant, afin d'accroître la sûreté de fonctionnement.

### ETAT DE LA TECHNIQUE

Le contrôle de l'isolement d'un réseau de distribution permet d'identifier l'occurrence d'un défaut : des paramètres sont mesurés de façon continue, et la diminution de la résistance d'isolement du réseau permet de détecter la présence d'un défaut pour réagir, par exemple en alarmant, et parfois en coupant un réseau ou une partie d'un réseau électrique. En particulier, un dispositif connu sous l'acronyme CPI, ou contrôleur permanent d'isolement, est classiquement raccordé au transformateur du réseau de façon à déterminer l'impédance d'isolement et d'évaluer une « anormalité » caractéristique de la présence d'un défaut : voir par exemple FR 2 647 220 ou EP 0 593 007.

Pour un réseau muni de dérivations, il peut en outre être important de localiser le défaut détecté au niveau central par le CPI, voire même de connaître parfaitement ses caractéristiques. Différentes méthodes ont été développées, dans lesquelles des moyens de mesure sont mis en place sur les dérivations, associés à des moyens de traitement et calcul, formant ainsi des « localisateurs » de défauts d'isolement, qui peuvent être mobiles ou à demeure: voir FR 2 963 679, FR 2 676 821, FR 2 917 838.

Une architecture de contrôle d'isolement est ainsi constituée d'un contrôleur d'isolement au niveau du transformateur, seul ou associé à des dispositifs de localisation de défaut au niveau des départs. Cependant, en cas de défaillance du contrôleur d'isolement, même si les relais sont à panne orientée, une non-détection d'un défaut ou inversement un déclenchement intempestif peuvent se produire. Or la redondance des équipements de mesure ne peut être préconisée pour chacun des appareils et/ou fonctions, que ce soit pour des raisons techniques, de coûts, d'encombrement ou de surface disponible de carte électronique dans les moyens de traitement.

### EXPOSE DE L'INVENTION

Parmi d'autres avantages, l'invention vise à proposer une solution simple et peu coûteuse pour accroître la sûreté de fonctionnement des systèmes de contrôle d'isolement existants, afin notamment de satisfaire aux normes IEC 61508 et IEC 61557-15.

L'invention concerne ainsi un procédé de contrôle de l'isolement d'un réseau électrique qui a plusieurs branches en aval d'un transformateur, comprenant l'injection d'un courant de tension prédéterminée et de fréquence différente de celle du réseau, par exemple 2,5 Hz pour un réseau triphasé à 50 Hz, et deux déterminations indépendantes de l'impédance d'isolement, la première par la mesure directe du courant injecté, la deuxième en aval du transformateur, notamment par l'intermédiaire d'un ou plusieurs tores. Chacune des deux valeurs d'impédance est comparée à un même seuil (par exemple une centaine d'ohms) qui, lorsqu'il n'est pas atteint (c'est-à-dire que l'impédance lui est inférieure, que le courant dépasse une valeur prédéfinie), permet de détecter l'occurrence d'un défaut d'isolement. Pour assurer une fiabilité maximale, en évitant qu'un défaut d'injection entraîne une non-détection, le procédé comprend également la vérification de la réalité de l'injection, en comparant la mesure du courant réalisée en aval du transformateur à une valeur fixée qui doit être dépassée ; cette comparaison de la mesure du courant est de préférence réalisée par l'intermédiaire de l'impédance d'isolement déterminée par ailleurs, ladite impédance devant rester sous un deuxième seuil, par exemple de l'ordre de 10 MΩ. Le procédé peut comprendre l'allumage d'un voyant ou l'activation d'un relai ; de préférence, l'indication est différenciée de façon à identifier quel résultat de comparaison est problématique.

Le procédé comprend également le contrôle de l'isolement pour les branches, par l'intermédiaire d'une comparaison similaire de l'impédance d'isolement des branches, déterminée sur la base de la mesure du courant à la fréquence d'injection y circulant, à un seuil qui peut être fixé pour chaque branche, notamment entre 10 kΩ et 1 MΩ. Les résultats des diverses comparaisons peuvent être indiqués de façon différenciée ou commune.

La mesure du courant en aval du transformateur est indépendante et réalisée par des moyens dédiés.

L'invention se rapporte aussi à un système de contrôle de l'isolement permettant la mise en oeuvre du procédé précédent. En particulier, le système de contrôle comprend des moyens pour injecter un signal de courant alterné de tension fixée sur la partie du réseau en amont du transformateur, au niveau du secondaire ou de préférence au niveau du neutre du transformateur. Le système de contrôle comprend un premier contrôleur permanent d'isolement, avec des moyens pour mesurer l'intensité du courant injecté et pour déterminer si l'impédance calculée à partir de cette intensité dépasse ou non un premier seuil.

Le système de contrôle comprend par ailleurs des moyens pour mesurer le courant à la fréquence d'injection en aval du transformateur, et des moyens pour vérifier que l'intensité mesurée est supérieure à une valeur seuil, ce qui permet de valider le bon fonctionnement des moyens d'injection, classiquement intégrés au contrôleur permanent d'isolement. Le système de contrôle comprend également des moyens de traitement et calcul du signal mesuré pour calculer l'impédance à partir de cette intensité en aval et des moyens pour déterminer si l'impédance calculée dépasse ou non le premier seuil ; le résultat de cette comparaison est ainsi redondant, ce qui permet d'augmenter la sécurité assurée par le système de contrôle, notamment dans les applications de type centrale nucléaire ou centre de données informatiques le requérant. La vérification de l'intensité du courant peut être réalisée par l'intermédiaire d'une comparaison de l'impédance calculée à un deuxième seuil.

De préférence, le système de contrôle comprend des moyens pour mesurer la tension à la fréquence d'injection en aval du transformateur, et les moyens de détermination des impédances utilisent cette mesure.

Le système de contrôle comprend en outre des moyens pour mesurer le courant à la fréquence d'injection au niveau des branches, de préférence de chacune, des moyens de traitement et calcul du signal pour calculer l'impédance à partir de cette intensité de branche et des moyens pour déterminer si l'impédance calculée dépasse ou non un seuil fixé en fonction des caractéristiques de charge de la branche, afin de localiser un éventuel défaut d'isolement.

Le localisateur ainsi formé par les moyens de mesure, les moyens de traitement et calcul et les moyens de détermination associés à chaque branche est adapté pour réaliser la deuxième mesure du courant à la fréquence d'injection, en aval du transformateur, et le traitement qu'elle subit. Avantageusement, les moyens de détermination et de comparaison du localisateur, élément du système en aval du transformateur, sont regroupés sur une même carte de calcul, par exemple une carte douze voies, qui permet de vérifier l'isolement de onze dérivations en sus de la vérification globale sur la douzième.

Le système de contrôle comprend enfin des moyens pour indiquer la suspicion de défaut d'isolement ou de défaut dans l'injection, par exemple des voyants lumineux. Selon un mode de réalisation, les indications sont différenciées, avec une sortie pour chaque type de résultat de comparaison défaillant détecté ; alternativement, les mêmes moyens peuvent se déclencher indifféremment du type de défaillance, par exemple avec un seul voyant s'allumant pour les deux comparaisons issues de la mesure du courant en aval du transformateur.

L'invention concerne également un réseau sécurisé par le système précédent.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1 illustre un réseau muni d'un système de contrôle de l'isolement selon un mode de réalisation préféré de l'invention.
Les figures 2A et 2B représentent les éléments amont et aval d'un système de contrôle selon un mode de réalisation de l'invention.

### DESCRIPTION DETAILLEE D'UN MODE DE REALISATION PREFERE

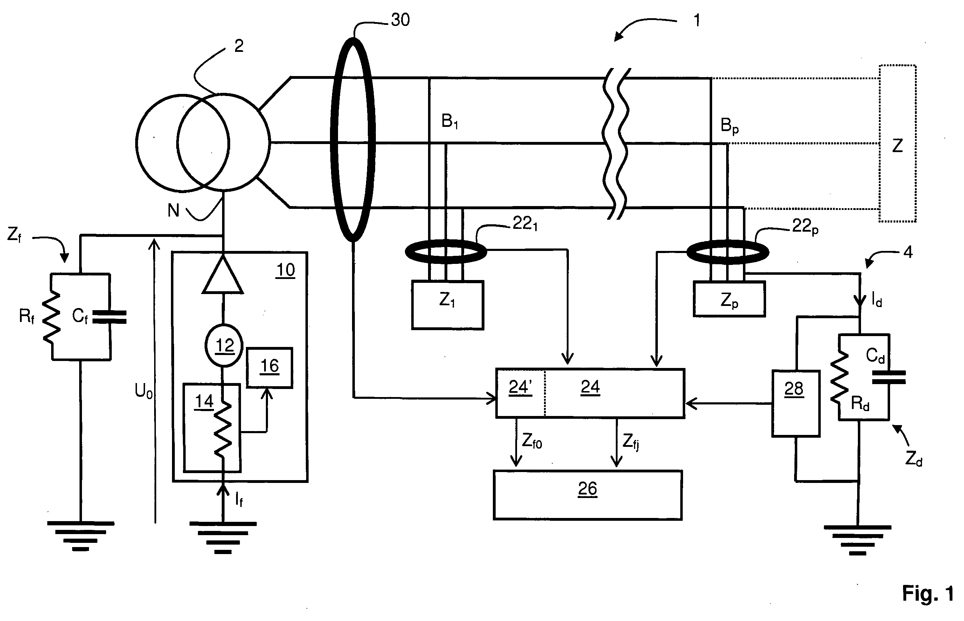

Tel qu'illustré en figure 1, les trois lignes de distribution d'un réseau triphasé 1 sont alimentées en énergie électrique alternative par un transformateur 2 ; en aval du transformateur 2, le réseau principal 1 fournit de l'énergie électrique à plusieurs impédances d'utilisation Zⱼ branchées chacune sur une branche triphasée Bⱼ (j = 1→p). En particulier, dans un appareillage selon l'invention, les départs Bⱼ sont concentrés en un lieu défini, par exemple au sein d'une armoire ou d'un poste de distribution. Le réseau 1 illustré est dit « à neutre isolé », c'est-à-dire que le neutre N du transformateur 2 est relié à la terre à la terre par une résistance (ou impédance) d'isolement du réseau 1 ; une résistance globale R_{f} peut ainsi être déterminée, constituée principalement des résistances d'isolement des câbles, des équipements,....

Lorsqu'une des impédances Zⱼ de charge ou d'utilisation présente un défaut d'isolement 4 par rapport à la terre, cela se traduit par la présence dommageable d'une impédance de défaut Z_{d} entre au moins un des trois fils de phase ou le neutre et la terre. Une impédance de défaut Z_{d} est usuellement schématisée par un circuit additionnel comprenant une résistance R_{d} en parallèle avec une capacité C_{d} ; cette impédance de défaut Z_{d} vient altérer (notamment diminuer) la valeur de l'impédance d'isolement « normale » Z_{f} du réseau 1 entre la borne neutre N du CPI 10 et la terre.

Pour détecter et mesurer la présence de ce type de fuite 4, un contrôleur permanent d'isolement, ou CPI, 10 est par exemple câblé entre le neutre N du transformateur 2 et la terre. Le CPI 10 comprend des moyens 12 pour générer et injecter sur le réseau d'alimentation 1 une tension alternative U₀ de fréquence f₁ différente et usuellement inférieure à la fréquence propre F₀ du réseau électrique 1 d'alimentation, notamment un sous-multiple. L'injection sur le réseau 1 entraîne la circulation d'un courant de fuite I_{f} qu'il est possible de mesurer au niveau du CPI par des moyens de mesure 14, notamment une résistance de mesure.

En présence du défaut d'isolement 4, le courant de fuite I_{f} circule dans l'impédance de défaut Z_{d} et se boucle vers le CPI 10 à travers la terre et les moyens de mesure 14 ; lorsqu'il dépasse un seuil, ce courant est alors nommé courant de défaut I_{d} et indique la présence d'un défaut 4.

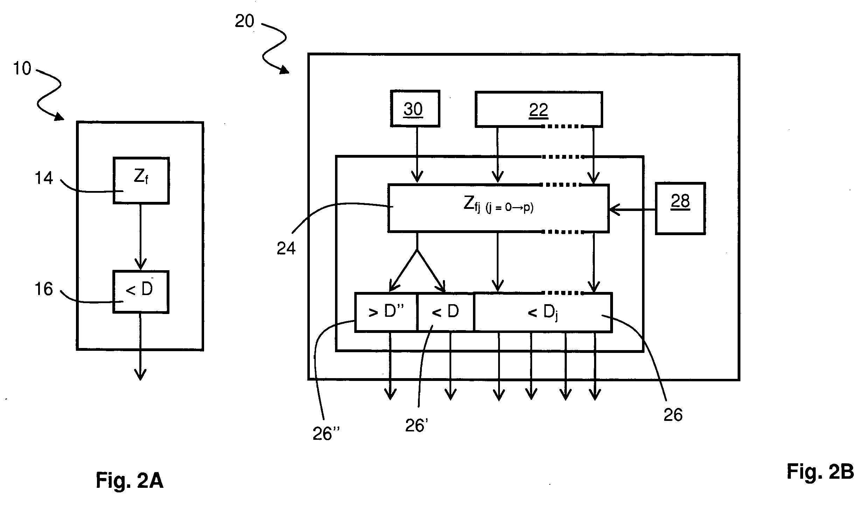

Un CPI 10 comprend ainsi classiquement des moyens 14 adaptés pour déterminer les valeurs de la résistance R_{f} et de la capacité C_{f} d'isolement, et des moyens 16 pour déterminer si ces valeurs ne correspondent pas à l'impédance « normale » du réseau 1, afin de donner une alarme (figure 2A). En particulier, en cas de défaut d'isolement 4, l'impédance d'isolement globale diminue : lorsqu'elle passe sous un premier seuil D, qui peut classiquement être fixé à une ou quelques centaines d'ohms, un signal sonore et/ou visuel prévient l'utilisateur de la probable occurrence d'un défaut 4. Accessoirement, des moyens pour visualiser les valeurs d'impédance d'isolement générale Z_{f} du réseau 1 peuvent être mis en place, ainsi que des moyens pour transmettre le résultat à une unité centrale pour action sur le réseau 1 (non illustré).

Par ailleurs, pour chacune des dérivations Bⱼ, un dispositif de localisation 20 de défaut d'isolement est mis en place (voir aussi figure 2B). Notamment, des moyens de mesure 22ⱼ du courant de défaut local transmettent le signal représentatif à des moyens de traitement et calcul 24, de préférence communs pour tous les moyens de mesure 22 ; la transmission peut être réalisée par tout moyen, mais pour sécuriser le système et comme l'application concerne de préférence un réseau 2 compact, des liaisons filaires sont préférées. Les moyens de traitement et calcul 24 et/ou les moyens de mesure 22 fonctionnent, indépendamment du CPI 10, de façon continue ou intermittente.

Selon l'option choisie, le localisateur 20 peut indiquer simplement la présence d'un défaut sur le départ, par exemple en comparant par des moyens adaptés 26 les impédances Z_{fj} calculées à chaque départ Bⱼ à un seuil Dⱼ déterminé en fonction des caractéristiques du départ Bⱼ, classiquement entre 10 KΩ et 1 MΩ, et qui doit être dépassé lorsque le départ Bⱼ est sain ; alternativement, le localisateur donne une mesure de l'impédance d'isolement Z_{fj} par des moyens adaptés connus de l'art antérieur.

Selon l'invention, le réseau 1 est sécurisé ; en particulier, le réseau 1 alimente des charges Z critiques qu'il convient de ne pas interrompre, comme un centre informatique ou une centrale nucléaire. Ainsi, le système de contrôle de l'isolement 10, 20 comprend un deuxième circuit d'alarme sur défaut d'isolement 4, indépendant du CPI 10 et qui donne une information redondante de sorte à identifier une défaillance au niveau du CPI 10 et éviter un retard dans le traitement d'un problème notifié par ce dispositif.

Comme les fonctions d'injection 12 et de détection 14 d'un CPI 10 sont étroitement imbriquées, la double mesure 14 du courant injecté sans double injection 12 est peu réaliste techniquement. Selon l'invention, une deuxième mesure est donc effectuée par l'intermédiaire du localisateur 20, qui a une fonction étendue de façon à ce qu'il puisse effectuer également une mesure de la résistance d'isolement du réseau complet 1, cette deuxième mesure étant redondante et indépendante de celle effectuée par le CPI 10.

Il importe donc également que le localisateur 20, et notamment ses moyens de traitement et calcul 24 soient indépendants du CPI 10 ; à cette fin, dans le mode de réalisation selon l'invention, le dispositif de localisation 20 comprend des moyens 28 pour mesurer la tension en aval du transformateur 2 de façon à calculer simplement les impédances Z_{fj} sur chaque départ Bⱼ.

De plus, dans le mode de réalisation préféré, pour diminuer au maximum les risques de défaillance, des moyens de mesure indépendants du courant injecté 30 sont mis en place en aval du transformateur 2 et donnent un signal représentatif du courant y circulant à la fréquence d'injection f₁, afin d'évaluer de façon redondante la réalité de l'injection par le CPI 10. Par exemple, lorsque toutes les dérivations Bⱼ sont munies de moyens de mesure 22ⱼ d'un localisateur 20 de défaut d'isolement (en l'absence de charges Z illustrées en pointillés sur la figure 1), les moyens de mesure 30 du courant injecté dans le réseau 1 comprennent des moyens pour faire la somme des courants mesurés par les moyens de mesure 22ⱼ associés à chaque dérivation Bⱼ (non illustré).

Cependant, pour s'affranchir du cumul des imprécisions de mesure, les moyens de mesure comprennent un tore 30 autour des trois conducteurs en sortie de transformateur 2. Cette réalisation permet une indépendance complète de la mesure redondante, et augmente la précision dans la valeur du paramètre mesuré afin d'évaluer plus avant la réalité du fonctionnement du CPI.

Cette information relative au courant injecté mesuré en aval du transformateur 2 est transmise à des moyens de calcul et traitement 24' pour déterminer l'impédance Z_{f0} y relative. En particulier, la même carte de calcul est utilisée pour le traitement des deux sortes de signaux, c'est-à-dire que la carte comprend une entrée spécifique pour le courant issus des moyens de mesure globaux 30 et une entrée pour la mesure 22ⱼ effectuée sur chaque branche Bⱼ ; le calcul de l'impédance de fuite globale Z_{f0} est lui aussi réalisé de la même manière que pour les autres moyens de mesure 22, notamment par l'intermédiaire de la mesure de la tension 28.

Le résultat Z_{f0} de cette deuxième mesure, correspondant à la mesure redondante de l'impédance d'isolement par les moyens de mesure situés en aval du transformateur 2, est ici encore comparée par des moyens adaptés 26' à un seuil D, qui est identique à celui utilisé pour la première mesure par le CPI 10 : si le seuil D n'est pas atteint, c'est-à-dire Z_{f0} < D < quelques 100 Ω et donc le courant détecté supérieur à un courant « normal » de fuite, des moyens d'alerte sont mis en oeuvre, de façon similaire à ce qui a été décrit préalablement pour le CPI 10. La redondance est ainsi complète, alors que ces deuxièmes moyens 24', 26', 30 d'identification de la présence d'un défaut 4 ont pour seul élément commun avec le CPI 10 l'utilisation du courant de mesure injecté.

Afin en outre de s'affranchir d'un problème dû à une panne potentielle de l'injection de courant à la fréquence f₁ de mesure par le CPI 10, les deuxièmes moyens de mesure 30 sont également utilisés pour vérifier la présence du courant injecté, c'est-à-dire le fonctionnement correct des moyens 12 dédiés. En particulier, si le courant global détecté par les moyens de mesure du courant 30 est inférieur à une valeur seuil, une alarme est déclenchée. La comparaison peut être réalisée directement sur le signal mesuré par des moyens dédiés (non illustré) ; alternativement, tel qu'indiqué en figure 2B, le résultat Z_{f0} du traitement et calcul de l'impédance de défaut globale est comparé à un deuxième seuil D" par des moyens 26" adaptés, le dépassement de ce deuxième seuil D" par l'impédance (Z_{f0} > D" > quelques 100 MΩ) indiquant que le courant injecté est insuffisant. L'alarme peut être commune pour le résultat du traitement du signal issu des deuxièmes moyens de mesure 30, ou différenciée, avec deux alarmes déclenchées suivant que le problème détecté est l'insuffisance de courant ou la présence d'un défaut.

De fait, aucun des dispositifs existants ne prend en compte l'option que le CPI 10 n'injecte pas de courant : dans les dispositifs existants, en cas de défaillance du CPI, il est considéré qu'il n'y a pas de défaut, l'impédance calculée étant infinie, et donc toujours supérieure au premier seuil D.

Ainsi, le réseau 1 est équipé d'un système 10, 20 d'identification et de localisation de défaut d'isolement 4 comprenant de préférence :
- un injecteur de courant 12, fonctionnant en permanence ;
- un contrôleur central d'isolement 10 branché sur le neutre du transformateur 2 et fonctionnant en permanence ;
- des moyens de mesure 22, 30 du courant à la fréquence injectée f₁ en aval du transformateur 2, pour mesurer en permanence le courant global du réseau 1 et le courant dans chaque branche Bⱼ dudit réseau 1 ;
- des moyens de mesure 28 de la tension à la fréquence d'injection f₁ en aval du transformateur 2 ;
- des moyens de traitement et calcul 24 des impédances en aval du transformateur 2, sur la base des mesures du courant et de la mesure de la tension ;
- des moyens de détermination 26" en permanence de la réalité de l'injection du courant par l'intermédiaire des moyens de mesure 30 aval ;
- des moyens 26' de contrôle de l'isolement en permanence du réseau 1 en aval du transformateur 2 ;
- des moyens 26 de localisation de défauts d'isolement sur les branches Bⱼ.

Les moyens de traitement et calcul 24, 26 en aval du transformateur 2 sont groupés, et totalement indépendants du contrôleur amont 10. Le système formé par le CPI 10 et les moyens de localisation 20 modifiés selon l'invention, permet d'améliorer le niveau de SIL (« *Safety Integrity Level* ») tel que défini dans les normes IEC 61508 et IEC 61557-15 en incrémentant la tolérance de défauts HFT (« *Hard Fault Tolerance* ») des fonctions d'alerte d'isolement local LIW (« *Local Insulation Warning* ») et d'alerte d'isolement éloigné RIW (« *Remote Insulation Warning* »). En particulier, les caractéristiques du système de contrôle 10, 20 sont définies pour satisfaire le critère SIL-2 (« *Safety Integrity Level 2* »), c'est-à-dire de réduire d'un facteur 100 à 1000 le risque d'apparition d'un danger, voire SIL-3 (réduction d'un facteur 1000 à 10000), ceci de façon peu onéreuse et peu gourmande en ressources de calcul et/ou moyens de traitement, sans rajouter de matériel (l'apparition d'un danger correspondant ici à la non détection d'un premier défaut sur le réseau 1 ayant pour conséquence potentielle un choc électrique ou une perte d'alimentation critique si un deuxième défaut survient alors que le premier défaut n'a pas été éliminé).

Bien que l'invention ait été décrite en référence à un réseau 1 triphasé sur le neutre N duquel est branchée l'injection 12 du système de contrôle permanent d'isolement 10, 20, elle ne s'y limite pas: la solution proposée peut être appliquée à des alimentations différentes, par exemple de fréquence autre que 50 Hz ou monophasée, ou des groupes de secours de type groupe électrogène ou onduleur ou des sources de tension continue, et/ou le dispositif d'injection 12 peut injecter son signal sur une phase du réseau. Les différentes méthodes d'identification, localisation et calcul peuvent être utilisées : par exemple, les moyens d'injection 12 peuvent être adaptés pour des injections simultanées ou consécutives à plusieurs fréquences et les moyens de mesure 22, 30 et traitement également...

## Revendications

1. Système de contrôle de l'isolement (4) dans un réseau (1) comprenant un transformateur (2) et une pluralité de dérivations (Bⱼ) en aval du transformateur (2), ledit système de contrôle (10, 20) comprenant un contrôleur permanent d'isolement (10) au niveau du transformateur (2), avec des moyens (12) d'injection d'un signal de courant alterné de tension prédéterminée (U₀) à une première fréquence (f₁), des moyens (14) pour mesurer l'intensité (I_{f}) du premier signal de courant, et des moyens (16) pour déterminer si l'impédance (Z_{f}) calculée en fonction de l'intensité (If) du premier signal de courant injecté est inférieure à un premier seuil (D), et au moins un localisateur (20) au niveau d'une dérivation (Bⱼ), le localisateur comprenant : des moyens (22ⱼ) pour mesurer l'intensité du signal de courant à la première fréquence (f₁) au niveau de la dérivation (Bⱼ), des moyens (24) de traitement et calcul pour calculer l'impédance (Z_{fj}) en fonction de l'intensité du signal de courant mesurée, des moyens (26) pour déterminer si l'impédance (Z_{fj}) calculée est inférieure à un seuil respectif if (Dⱼ), ledit système comprenant en outre des moyens indicateurs pour indiquer si un des seuils respectifs (Dⱼ) est atteint;
**caractérisé en ce que** le système le contrôle comporte en outre :
- des moyens de mesure globaux (30) pour mesurer l'intensité du signal de courant global à la première fréquence (f₁) dans le réseau (1) en aval du transformateur (2) ; lesdits des moyens de mesure globaux (30) étant en sortie dudit transformateur (2) ;
- des moyens (26") pour déterminer si l'intensité du signal de courant global en aval à la première fréquence (f₁) est supérieure à une valeur seuil ;
- des moyens (24) de traitement et calcul pour donner une deuxième valeur d'impédance (Z_{f0}) en fonction de l'intensité du signal de courant global en aval à la première fréquence (f₁) ;
- des moyens (26') pour déterminer si la deuxième valeur d'impédance (Z_{f0}) est inférieure au premier seuil (D) ;
- des moyens indicateurs pour indiquer si le premier seuil (D) n'est pas atteint et/ou si la valeur seuil est dépassée.

2. Système de contrôle selon la revendication 1 dans lequel les moyens indicateurs permettent d'indiquer lequel parmi les premier seuil (D) et valeur seuil n'est pas atteint ou dépassé.

3. Système de contrôle selon l'une des revendications 1 ou 2 dans lequel les moyens (26") pour déterminer si l'intensité du signal de courant aval à la première fréquence (f₁) est supérieure à une valeur seuil sont adaptés pour utiliser la deuxième valeur d'impédance (Z_{f0}) et la comparer à un deuxième seuil (D").

4. Système de contrôle selon l'une des revendications 1 à 3 dans lequel les moyens indicateurs permettent d'indiquer lequel de chacun des seuils respectifs (Dⱼ) est atteint.

5. Système de contrôle selon l'une des revendications 1 à 4 dans lequel les moyens de traitement et calcul de l'impédance (24) sont communs à tous les localisateurs du système.

6. Système de contrôle selon l'une des revendications 1 à 5 dans lequel les seuils respectifs (Dⱼ) ne sont pas égaux entre eux.

7. Système de contrôle selon l'une des revendications 1 à 6 dans lequel les moyens de calcul et traitement (24) comprennent une carte avec plusieurs voies.

8. Système de contrôle selon la revendication 7 dans lequel la carte comprend une voie d'entrée pour calculer la deuxième valeur d'impédance (Z_{f0}) et les autres voies sont adaptées pour permettre de calculer l'impédance (Z_{fj}) de chaque branche (Bⱼ),

9. Système de contrôle selon l'une des revendications 1 à 8 dans lequel chaque dérivation (Bⱼ) du réseau (1) comprend un localisateur, et les moyens (30) pour mesurer l'intensité du signal de courant à la première fréquence (f₁) en aval du transformateur (2) comprennent des moyens pour faire la somme de toutes les intensités détectées par les localisateurs.

10. Système de contrôle selon l'une des revendications 1 à 8 dans lequel les moyens (30) pour mesurer l'intensité du signal de courant à la première fréquence (f₁) en aval du transformateur (2) comprennent un tore de détection (30) placé autour des lignes du réseau (1) en aval du transformateur (2).

11. Système de contrôle selon l'une des revendications 1 à 10 comprenant en outre des moyens (28) pour mesurer la tension à la première fréquence en aval du transformateur (2), et les moyens de traitement et calcul (24) des impédances sont adaptés pour utiliser la valeur de la tension.

12. Procédé de contrôle de la présence d'un défaut (4) d'isolement sur un réseau électrique triphasé (1) avec une pluralité de branches (Bⱼ) en aval d'un transformateur (2) comprenant :
- l'injection d'un courant de tension prédéterminée (U₀) à une première fréquence (f₁) différente de la fréquence du réseau (1) au niveau du transformateur (2) ;
- la détermination d'une première valeur (Z_{f}) de l'impédance d'isolement au niveau de l'injection par l'intermédiaire de la mesure (I_{f}) du courant injecté ;
- la mesure du courant à la première fréquence au niveau du transformateur (2) ;
- la comparaison dudit courant à une valeur seuil ;
- la détermination d'une deuxième valeur (Z_{f0}) de l'impédance d'isolement par l'intermédiaire de la mesure de courant global circulant dans le réseau (1) à la première fréquence (f₁) en aval en sortie du transformateur (2) ;
- la comparaison des première et deuxième valeurs d'impédance d'isolément à un premier seuil (D),
- la détermination de l'impédance d'isolement (Z_{fj}) au niveau de chaque branche (Bⱼ) et la comparaison de ladite impédance (Z_{fj}) à un seuil (D_{f}) de chaque branche (Bⱼ).

13. Réseau électrique sécurisé (1) comprenant un transformateur (2) triphasé alimentant une pluralité de dérivations (Bⱼ), ledit réseau (1) étant équipé d'un système de contrôle selon l'une des revendications 1 à 11.

## Patentansprüche

1. System zur Überwachung von Isolationsfehlern (4) in einem Leitungsnetz (1) mit einem Transformator (2) und mehreren, auf der Abgangsseite des Transformators (2) angeschlossenen Abgängen (Bⱼ), welches Überwachungssystem (10, 20) eine an den Transformator (2) angeschlossene Isolations-Überwachungseinrichtung (10) mit Mitteln zur Injektion eines Wechselstromsignals einer bestimmten Spannung (U₀) und einer ersten Frequenz (f₁), Mitteln (14) zur Messung des Stromwertes (I_{f}) des ersten Stromsignals sowie mit Mitteln (16) umfasst, um zu bestimmen, ob die in Abhängigkeit vom Stromwert (I_{f}) des ersten, injizierten Stromsignals berechnete Impedanz (Z_{f}) unter einer ersten Schwelle (D) liegt, sowie mindestens eine, in einen Abgang (Bⱼ) geschaltete Fehlerortungseinrichtung (20), welche Fehlerortungseinrichtung Mittel (22ⱼ) zur Messung des Wertes des Stromsignals mit der ersten Frequenz (f₁) im Abgang (Bⱼ), Verarbeitungsund Rechenmittel (24) zur Berechnung der Impedanz (Z_{fj}) in Abhängigkeit vom Messwert des Stromsignals sowie Mittel (26) umfasst, um zu bestimmen, ob die berechnete (Z_{fj}) Impedanz unter einer zugeordneten Schwelle (Dⱼ) liegt, wobei das System außerdem Anzeigemittel umfasst, um anzuzeigen, ob eine der zugeordneten Schwellen (Dⱼ) erreicht wurde, **dadurch gekennzeichnet, dass** das Überwachungssystem darüber hinaus folgende Komponenten umfasst:
- Gesamtmessmittel (30) zur Messung des Wertes des Gesamtstromsignals mit der ersten Frequenz (f₁) im Netz auf der Abgangsseite des Transformators (2), welche Gesamtmessmittel (30) an den Ausgang des genannten Transformators (2) geschaltet sind,
- Mittel (26") um zu bestimmen, ob der Wert des abgangsseitigen Stroms mit der ersten Frequenz (f₁) über einem bestimmten Schwellwert liegt,
- Verarbeitungs- und Rechenmittel (24) zur Bereitstellung eines zweiten Impedanzwertes (Z_{f0}) in Abhängigkeit vom Wert des abgangsseitigen Stromsignals mit der ersten Frequenz (f₁),
- Mittel (26') um zu bestimmen, ob der zweite Impedanzwert (Z_{f0}) unter der ersten Schwelle (D) liegt, sowie
- Anzeigemittel um anzuzeigen, ob die erste Schwelle (D) nicht erreicht wurde und/oder ob der Schwellwert überschritten wurde.

2. Überwachungssystem nach Anspruch 1, **dadurch gekennzeichnet, dass** die Anzeigemittel dazu ausgelegt sind selektiv anzuzeigen, ob die erste Schwelle (D) oder der Schwellwert nicht erreicht bzw. überschritten wurde.

3. Überwachungssystem nach Anspruch 1 oder 2, beim die Mittel (26") zur Bestimmung, ob der Wert des abgangsseitigen Stromsignals der ersten Frequenz (f₁) über einem bestimmten Schwellwert liegt, so ausgelegt sind, dass sie den zweiten Impedanzwert (Z_{f0}) verwenden und ihn mit einer zweiten Schwelle (D") vergleichen.

4. Überwachungssystem nach einem der Ansprüche 1 bis 3, **dadurch gekennzeichnet, dass** die Anzeigemittel dazu ausgelegt sind, selektiv anzuzeigen, welche der zugeordneten Schwellen (Dⱼ) erreicht wurde.

5. Überwachungssystem nach einem der Ansprüche 1 bis 4, **dadurch gekennzeichnet, dass** die Verarbeitungs- und Rechenmittel (24) allen Fehlerortungseinrichtungen des Systems gemeinsam zugeordnet sind.

6. Überwachungssystem nach einem der Ansprüche 1 bis 5, bei dem die zugeordneten Schwellen (Dⱼ) unterschiedliche Werte aufweisen.

7. Überwachungssystem nach einem der Ansprüche 1 bis 6, bei dem die Verarbeitungs- und Rechenmittel (24) eine Karte mit mehreren Signalkanälen umfassen.

8. Überwachungssystem nach Anspruch 7, bei dem die Karte einen Eingangskanal zur Berechnung des zweiten Impedanzwertes (Z_{f0}) umfasst und die übrigen Kanäle zur Berechnung der Impedanz (Z_{fj}) in den einzelnen Abzweigen (Bj) verwendet werden können.

9. Überwachungssystem nach einem der Ansprüche 1 bis 8, bei dem jeder Abzweig (Bⱼ) des Netzes (1) eine Fehlerortungseinrichtung umfasst und die Mittel (30) zur Messung des Wertes des Stromsignals mit der ersten Frequenz (f₁) auf der Abgangsseite des Transformators (2) Mittel zur Summenbildung aller von den Fehlerortungseinrichtungen erfassten Ströme umfassen.

10. Überwachungssystem nach einem der Ansprüche 1 bis 8, bei dem die Mittel (30) zur Messung des Wertes des Stromsignals mit der ersten Frequenz (f₁) auf der Abgangsseite des Transformators (2) einen auf der Abgangsseite des Transformators (2) um die Leiter des Netzes (1) geführten Messstromwandler (30) umfassen.

11. Überwachungssystem nach einem der Ansprüche 1 bis 10, das darüber hinaus Mittel (28) zur Messung der Spannung mit der ersten Frequenz auf der Abgangsseite des Transformators (2) umfasst, wobei die Verarbeitungs- und Rechenmittel (24) zur Bestimmung der Impedanzen dazu ausgelegt sind, den Spannungswert zu verwenden.

12. Überwachungsverfahren zur Erkennung eines Isolationsfehlers (4) in einem elektrischen Dreiphasennetz (1) mit mehreren Abzweigen (Bⱼ) auf der Abgangsseite des Transformators (2), welches Verfahren folgende Schritte umfasst:
- Injektion eines Stroms mit einer bestimmten Spannung (U₀) und einer ersten Frequenz (f₁) am Transformator (2), die von der Frequenz des Leitungsnetzes (1) abweicht,
- Bestimmung eines ersten Wertes (Z_{f}) des Isolationswiderstands an der Injektionsstelle über den gemessenen Wert (I_{f}) des injizierten Stroms,
- Messung des Stroms mit der ersten Frequenz am Transformator (2),
- Vergleich des genannten Stroms mit einem Schwellwert,
- Bestimmung eines zweiten Wertes (Z_{f0}) des Isolationswiderstands über den Messwert des auf der Abgangsseite des Transformators (2) im Leitungsnetz (1) fließenden Stroms mit der ersten Frequenz (f₁),
- Vergleich des ersten und des zweiten Wertes des Isolationswiderstands mit einer ersten Schwelle (D),
- Bestimmung des Isolationswiderstands (Z_{fj}) in jedem Abzweig (Bⱼ) und Vergleich des genannten Isolationswiderstands (Z_{fj}) mit einer Schwelle (D_{f}) jedes Abzweigs (Bⱼ).

13. Sicheres elektrisches Leitungsnetz (1) mit mehreren, über einen Dreiphasen-Transformator (2) eingespeisten Abgängen (Bⱼ), welches Netz (1) mit einem Überwachungssystem nach einem der Ansprüche 1 bis 11 ausgerüstet ist.

## Claims

1. System for monitoring the insulation (4) in a network (1) comprising a transformer (2) and a plurality of tappings (Bj) downstream of the transformer (2), said monitoring system (10, 20) comprising a permanent insulation monitor (10) at the level of the transformer (2), with means (12) for injecting an alternating current signal of predetermined voltage (U₀) at a first frequency (f₁), means (14) for measuring the intensity (I_{f}) of the first current signal, and means (16) for determining whether the impedance (Z_{f}) calculated as a function of the intensity (I_{f}) of the first injected current signal is below a first threshold (D), and at least one locator (20) at the level of a tapping (Bj), the locator comprising: means (22ⱼ) for measuring the intensity of the current signal at the first frequency (f₁) at the level of the tapping (Bⱼ), processing and calculation means (24) for calculating the impedance (Z_{fj}) as a function of the measured intensity of the current signal, means (26) for determining whether the calculated impedance (Z_{fj}) is below a respective threshold (Dⱼ), said system furthermore comprising indicator means for indicating whether one of the respective thresholds (Dⱼ) is attained;
**characterized in that** the monitoring system further comprises:
- global measurement means (30) for measuring the intensity of the global current signal at the first frequency (f₁) in the network (1) downstream of the transformer (2); said global measurement means (30) being at the output of said transformer (2);
- means (26") for determining whether the intensity of the downstream global current signal at the first frequency (f₁) is above a threshold value;
- processing and calculation means (24) for giving a second impedance value (Z_{f0}) as a function of the intensity of the downstream global current signal at the first frequency (f₁);
- means (26') for determining whether the second impedance value (Z_{f0}) is below the first threshold (D);
- indicator means for indicating whether the first threshold (D) is not attained and/or whether the threshold value is exceeded.

2. Monitoring system according to Claim 1 in which the indicator means make it possible to indicate which from among the first threshold (D) and threshold value is not attained or exceeded.

3. Monitoring system according to either of Claims 1 and 2 in which the means (26") for determining whether the intensity of the downstream current signal at the first frequency (f₁) is above a threshold value are suitable for using the second impedance value (Z_{f0}) and comparing it with a second threshold (D").

4. Monitoring system according to one of Claims 1 to 3 in which the indicator means make it possible to indicate which from among each of the respective thresholds (Dⱼ) is attained.

5. Monitoring system according to one of Claims 1 to 4 in which the means (24) for processing and calculation of the impedance are common to all the locators of the system.

6. Monitoring system according to one of Claims 1 to 5 in which the respective thresholds (Dⱼ) are not mutually equal.

7. Monitoring system according to one of Claims 1 to 6 in which the calculation and processing means (24) comprise a card with several pathways.

8. Monitoring system according to Claim 7 in which the card comprises an input pathway for calculating the second impedance value (Z_{f0}) and the other pathways are suitable for making it possible to calculate the impedance (Z_{fj}) of each branch (Bⱼ).

9. Monitoring system according to one of Claims 1 to 8 in which each tapping (Bⱼ) of the network (1) comprises a locator, and the means (30) for measuring the intensity of the current signal at the first frequency (f₁) downstream of the transformer (2) comprise means for summing all the intensities detected by the locators.

10. Monitoring system according to one of Claims 1 to 8 in which the means (30) for measuring the intensity of the current signal at the first frequency (f₁) downstream of the transformer (2) comprise a detection torus (30) placed around the lines of the network (1) downstream of the transformer (2).

11. Monitoring system according to one of Claims 1 to 10 furthermore comprising means (28) for measuring the voltage at the first frequency downstream of the transformer (2), and the means (24) for processing and calculation of the impedances are suitable for using the value of the voltage.

12. Method of monitoring the presence of an insulation fault (4) on a three-phase electrical network (1) with a plurality of branches (Bⱼ) downstream of a transformer (2) comprising:
- the injection of a current of predetermined voltage (U₀) at a first frequency (f₁) different from the frequency of the network (1) at the level of the transformer (2);
- the determination of a first value (Z_{f}) of the insulation impedance at the level of the injection by way of the measurement (I_{f}) of the injected current;
- the measurement of the current at the first frequency at the level of the transformer (2);
- the comparison of said current with a threshold value;
- the determination of a second value (Z_{f0}) of the insulation impedance by way of the measurement of global current flowing in the network (1) at the first frequency (f₁) downstream at the output of the transformer (2);
- the comparison of the first and second insulation impedance values with a first threshold (D),
- the determination of the insulation impedance (Z_{fj}) at the level of each branch (Bⱼ) and the comparison of said impedance (Z_{fj}) with a threshold (Dⱼ) of each branch (Bⱼ).

13. Secure electrical network (1) comprising a three-phase transformer (2) supplying a plurality of tappings (Bⱼ), said network (1) being equipped with a monitoring system according to one of Claims 1 to 11.
